# EUROPEAN PATENT APPLICATION

(11) **EP 4 773 100 A1**
(43) Date of publication of application: **08.07.2026**
(21) Application number: 25221461.4
(22) Date of filing: 08.12.2025
(51) Int. Cl.: G06V 20/10, G06V 20/52, G01R 19/155

(54) **ARTIFICIAL INTELLIGENCE-BASED STRAY VOLTAGE DETECTION SYSTEM**

(30) Priority: 07.01.2025 US 202563742693 P
(71) Applicant: Osmose Utilities Services, Inc., Lithia Springs, GA 30122 (US)
(72) Inventor: MORE, Randal Kopp, Lafayette, New York 13084 (US); KALOKITIS, David NMN, Ship Bottom, New Jersey 08008 (US)
(74) Representative: Viering, Jentschura & Partner mbB Patent- und Rechtsanwälte

(57) **Abstract**

An apparatus for determining a stray voltage source is provided and comprises an object recognition system configured to detect an object and an artificial intelligence algorithm configured to analyze the object and apply rule-based criteria to determine a probability of stray voltage associated with the object.

## Description

### BACKGROUND

### Field of the Disclosure

The present disclosure relates to the detection of electric fields, and more particularly, to artificial intelligence-based stray voltage detection systems configured to determine potentially hazardous energized objects.

### Description of the Related Art

Power distribution systems, for example those in large metropolitan areas, are subject to many stresses, which may occasionally result in the generation of undesirable or dangerous anomalies. An infrequent but recurrent problem in power distribution infrastructures is the presence of "stray voltages" in the system. These stray voltages may present themselves when objects, such as manhole covers, gratings, street light poles, phone booths, and the like, become electrically energized (e.g., at 120V AC). These objects may become energized when an electrically conductive path is established between underground secondary cabling and these objects, for example, due to physical damage to electrical insulation that results in direct contact between electrically conductive elements, or through the introduction of water acting as a conductor. These energized objects present obvious dangers to people and animals in the general public.

To identify energized objects throughout a large area, such as a large urban area, a mobile system may be utilized to traverse the area and remotely (i.e., in a non-contact manner) detect stray voltages on energized objects. One technique for detecting such stray voltages is by measuring the electric field pattern exhibited by energized objects at the fundamental power line frequency (e.g., 60 Hz in the U.S., 50 Hz in Europe and parts of Asia). While such mobile systems are suitable for detecting stray voltages on energized objects, they can be time consuming, may detect false positives -which may occur when an object emits an electric field pattern resembling that of a potentially hazardous energized structure while not being energized in a fashion that could cause shock or electrocution- and may require a technician operating a conventional mobile detection system to stop and make time-consuming manual inspections of the structure.

Therefore, the inventors provide herein improved artificial intelligence-based stray voltage detection systems configured to determine potentially hazardous energized objects.

### SUMMARY

Embodiments of the present disclosure generally relate to innovative methods and apparatus that employs artificial intelligence (AI) to automate detection and evaluation of stray voltage sources in various environments. In at least some embodiments, the methods and apparatus described herein integrate Al image object detection technology with a comprehensive rule base to analyze and/or interpret images or data from an environment, aiming to identify potential sources of stray voltage.

In accordance with at least some embodiments, there is provided an apparatus for determining a stray voltage source. The apparatus can comprise an object recognition system configured to detect an object and an artificial intelligence algorithm configured to analyze the object and apply rule-based criteria to determine a probability of stray voltage associated with the object.

In accordance with at least some embodiments, there is provided a method for determining a stray voltage source. The method can comprise detecting an object using an object recognition system and analyzing the object and applying rule-based criteria using an artificial intelligence algorithm configured to determine a probability of stray voltage associated with the object.

In accordance with at least some embodiments, there is provided a non-transitory computer readable storage medium having instructions stored thereon that when executed by a processor perform a method for determining a stray voltage source. The method can comprise detecting an object using an object recognition system and analyzing the object and applying rule-based criteria using an artificial intelligence algorithm configured to determine a probability of stray voltage associated with the object.

### BRIEF DESCRIPTION OF THE DRAWINGS

Embodiments of the present disclosure, briefly summarized above and discussed in greater detail below, can be understood by reference to the illustrative embodiments of the disclosure depicted in the appended drawings. It is to be noted, however, that the appended drawings illustrate only typical embodiments of this disclosure and are therefore not to be considered limiting of its scope, for the disclosure may admit to other equally effective embodiments.
Figure 1 is a block diagram of a system for detecting potentially hazardous energized structures in accordance with one or more embodiments of the present disclosure;
Figure 2 is a block diagram of a processor in accordance with one or more embodiments of the present disclosure;
Figure 3 is a graphical diagram for discriminating between potentially hazardous and non-hazardous electric field sources in accordance with one or more embodiments of the present disclosure;
Figure 4 is a flow diagram of a method for discriminating between potentially hazardous and non-hazardous electric field sources in accordance with one or more embodiments of the present disclosure;
Figure 5 is a pair of graphical diagrams depicting exemplary data for discriminating between potentially hazardous and non-hazardous electric field sources in accordance with one or more embodiments of the present disclosure;
Figure 6 is a flowchart of a method for determining a stray voltage source in accordance with one or more embodiments of the present disclosure; and
Figure 7 is a block diagram of the system of Figure 1 comprising an apparatus for determining a stray voltage source in accordance with one or more embodiments of the present disclosure.

### DETAILED DESCRIPTION

Embodiments of the present disclosure generally relate to apparatus and methods for discriminating between potentially hazardous and non-hazardous sources of electric fields. For example, an apparatus for determining a stray voltage source can comprise an object recognition system configured to detect an object and an artificial intelligence algorithm configured to analyze the object and apply rule-based criteria to determine a probability of stray voltage associated with the object. The methods and apparatus described herein can detect subtle visual cues and anomalies that may indicate the presence of stray voltage, thus replacing the need for operator-based situational awareness and experience.

The methods and apparatus described herein are configured for use with one or more mobile detection systems that are configured for detecting potentially hazardous energized structures. One such system is described in commonly assigned U.S. Patent No. 8,577,631, entitled "Method and Apparatus for Discrimination of Sources in Stray Voltage Detection, issued November 5, 2013," the entire contents of which is incorporated herein by reference.

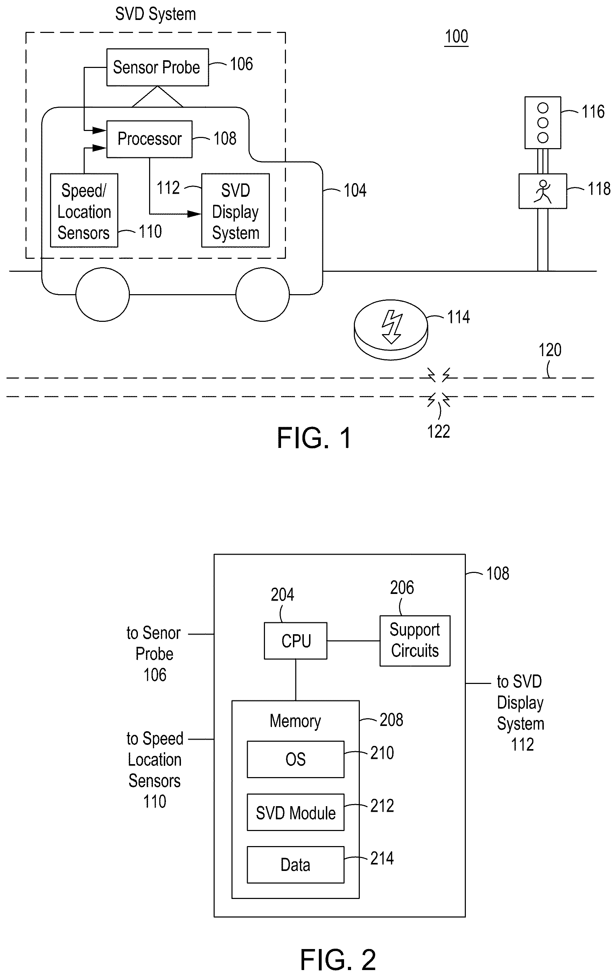

For example, Figure 1 is a block diagram of a system 100 for detecting potentially hazardous energized structures in accordance with one or more embodiments of the present disclosure. The system 100 comprises a stray voltage detection (SVD), a mobile vehicle 104, a manhole cover 114 (a potentially hazardous energized manhole cover), and a streetlight 116 coupled to a crossing sign 118 (e.g., pedestrian crossing sign) that is a potentially non-hazardous source of an electric field. Additionally, the system 100 comprises cabling 120 (e.g., subterranean power distribution system), the cabling 120 having a fault 122 (such as insulation damage).

The fault 122 results in the manhole cover 114 being electrically energized by a power line conductor within the cabling 120, causing the manhole cover 114 to exhibit an electric field pattern primarily at the fundamental frequency of the power line (e.g., 60 Hz for a U.S. power distribution system). The manhole cover 114, energized in such a way, exhibits a voltage at its surface (i.e., a stray voltage) and thus presents a potential electric shock hazard to a pedestrian or animal coming in contact with the manhole cover 114. In one or more alternative embodiments, the manhole cover 114 and/or other objects may become similarly energized in a potentially hazardous fashion due to other types of electrical system faults; for example, a streetlight may become energized due to an electrical fault within the streetlight that shorts the power line conductor to the street light casing.

In contrast to the manhole cover 114, the crossing sign 118 is electrically energized by a power source but does not exhibit a voltage at its surface. The crossing sign 118 thus generally does not represent a potential electric shock hazard. The crossing sign 118 comprises light emitting diodes (LEDs) that emit an electric field pattern similar to that of a potentially hazardous energized object (e.g., the manhole cover 114) but, due to a rectification occurring in the diode structure of the LEDs, additionally comprises a relatively large component at one or more frequencies other than the fundamental power line frequency, such as, a harmonic of the fundamental power line frequency. In some alternative embodiments, the crossing sign 118 and/or other objects may similarly act as a potentially non-hazardous electric field source and exhibit an analogous electric field pattern having significant components at one or more frequencies other than the fundamental power line frequency, such as, a harmonic of the fundamental power line frequency.

The SVD system 102 is capable of detecting and providing an indication of stray voltages present on hazardous energized objects, such as the manhole cover 114, as well as discriminating between such potentially hazardous energized objects and potentially non-hazardous electric field sources, such as the crossing sign 118. The SVD system 102 is generally transported by the mobile vehicle 104, which may be a car, van, truck, cart, or the like, for patrolling an area to identify potentially hazardous energized objects. The SVD system 102 comprises a sensor probe 106, speed/location sensors 110, and an SVD display system 112, each coupled to a processor 108.

The sensor probe 106 may be mounted to the mobile vehicle 104, towed by the mobile vehicle 104, or similarly conveyed by the mobile vehicle 104 for measuring an electric field in the area patrolled by the mobile vehicle 104. The sensor probe 106 produces one or more electrical signals representative of strength of the electric field in the area and couples the generated electrical signals to the processor 108. Examples of such a sensor probe may be found in commonly assigned U.S. patent 7,248,054, entitled "Apparatus and Method for Detecting an Electric Field", issued July 24, 2007; commonly assigned U.S. patent 7,253,642, entitled "Method for Sensing an Electric Field", issued August 7, 2007; and commonly assigned U. S. patent application publication number 2009/0195255 entitled "Apparatus and Method for Monitoring and Controlling Detection of Stray Voltage Anomalies" and filed January 21, 2009, the entire contents of each of these applications is incorporated herein by reference. In some embodiments, more than one sensor probe 106 may be utilized for measuring the electric field. Additionally or alternatively, the SVD system 102 may further comprise one or more components known in the art, such as filters, analog to digital converters (ADC), amplifiers, and the like, for processing the electrical signals generated by the sensor probe 106.

The processor 108 processes the electrical signals received from the sensor probe 106 to generate a first field strength -i.e., a measurement of the electric field strength at the fundamental frequency of the power distribution system ("field strength at a first frequency") for providing an indication of a stray voltage present on an object. In some embodiments, the power distribution system may have a fundamental frequency of 60 Hz. In other embodiments, the power distribution system may be at a different frequency, such as 50 Hz. The field strength at the first frequency may be used to generate the stray voltage indication as a visual indication displayed by the SVD display system 112, e.g., a graphical display of the field strength at the first frequency compared to a threshold. Additionally or alternatively, the field strength at the first frequency may be used to generate a stray voltage indication as an audible indication, such as a continuous tone proportional in pitch to the strength of the first electric field strength value. In such embodiments where an audible stray voltage indication is generated, the processor 108 and/or the SVD display system 112 comprises a speaker for presenting the audible indication.

The processor 108 additionally receives information from the speed/location sensors 110 for determining a speed and/or a location of the sensor probe 106, as well as a time stamp corresponding to sensor probe measurements obtained. The speed/location sensors 110 may include one or more of a wheel speed sensor, a wheel revolution sensor, a Global Positioning System (GPS) receiver, an imaging device (e.g., a camera, video camera, stereo camera, or the like), a speed sensor, a location device, or the like, for obtaining speed and/or location data and providing such data to the processor 108. The speed and/or location data may be utilized by the processor 108 during processing to generate the field strength at a first frequency, correlated with the electrical signals and/or field strength at a first frequency for display and/or storage, displayed on the SVD display system 112, and/or similarly utilized by the SVD system 102.

The SVD display system 112 provides a means for displaying data to a user, such as the electrical signals generated by the sensor probe 106, speed and/or location data obtained by the speed/location sensors 110, processed data from the processor 108 (e.g., the field strength at a first frequency), and/or combinations of the aforementioned. In some embodiments, one or more of the speed/location sensors 110 may additionally or alternatively be coupled directly to the SVD display system 112 for displaying speed and/or location data. The SVD display system 112 may comprise a graphical user interface (GUI) for displaying data as well as providing operative control of the SVD system 102; additionally, the SVD display system 112 may comprise a conventional laptop computer for storing data and/or for further analysis of data.

Examples of a system such as the SVD system 102 for indicating a stray voltage at a fundamental power line frequency may be found in commonly assigned U.S. patent 7,248,054, entitled "Apparatus and Method for Detecting an Electric Field", issued July 24, 2007; commonly assigned U.S. patent 7,253,642, entitled "Method for Sensing an Electric Field" and issued August 7, 2007; commonly assigned U.S. patent 7,486,081, entitled "Apparatus and Method for Monitoring and Controlling Detection of Stray Voltage Anomalies" and issued February 3, 2009; and commonly assigned U. S. patent application publication number 2009/0195255, entitled "Apparatus and Method for Monitoring and Controlling Detection of Stray Voltage Anomalies" and filed January 21, 2009, the entire contents of each of these applications is incorporated herein by reference.

In accordance with one or more embodiments of the present disclosure, the processor 108 generates a second field strength and a third field strength -i.e., measurements of the electric field strength at a second and a third frequency ("field strength at a second frequency" and "field strength at a third frequency", respectively), based on the electrical signals received from the sensor probe 106. The second and third frequencies may be second and third harmonics of the power distribution system's fundamental frequency, although they are not limited to harmonics of the fundamental frequency. The field strengths at the first, second, and/or third frequencies may then be compared in order to discriminate between potentially hazardous energized objects (e.g., the manhole cover 114) and potentially non-hazardous sources of electric fields (e.g., the crossing sign 118). The comparison of the field strengths may be expressed in absolute and/or relative values.

Field strength measurements at other frequencies may additionally or alternatively be utilized. In some embodiments, the processor 108 performs narrow band filtering at each frequency measured, including the measurement at the fundamental frequency.

In some embodiments, the processor 108 may compare the field strengths at the first, second, and/or third frequencies and generate an indication, such as a visual and/or audible alarm, or the like, signifying whether an object is determined to be a potentially hazardous or non-hazardous source of the electric field. Additionally or alternatively, the processor 108 may generate a graphical display of the field strengths at the first, second, and/or third frequencies for presentation by the SVD display system 112. In some such embodiments, the graphical display may be correlated with location information, such as visual imagery, latitude/longitude, an address, or the like, corresponding to the locations at which the electric field strength was measured by the sensor probe 106. In an alternative embodiment, the processor 108 may additionally or alternatively compute the electric field strength at one or more other frequencies for additional analysis of stray voltages.

Some specific objects, such as the crossing sign 118, may be characterized by a group of field strength values exhibiting a certain signature and thereby recognized as being typically non-hazardous objects. For example, if the field strengths for a measured object at the second and third frequencies satisfy first and second thresholds, respectively, related to the field strength at the first frequency (e.g., the field strength at the second frequency is greater than 10% of the fundamental frequency level and the field strength at the third frequency is less than 5% of the fundamental frequency level), the object may be determined to be the crossing sign 118. Additionally or alternatively, other types of signature analysis may be utilized. For objects that may be so characterized and determined to be typically non-hazardous objects, the SVD system 102 may provide a specific indication that the object is typically non-hazardous and requires no further investigation. Alternatively, the SVD system 102 may suppress an indication (e.g., a visual alarm, an audible alarm, or the like) of a detected electric field radiated from the object. Such characterization of typically non-hazardous objects may thereby improve the speed and efficiency of identifying potentially hazardous objects by allowing the user to bypass typically non-hazardous objects that are radiating an electric field.

Figure 2 is a block diagram of a processor 108 in accordance with one or more embodiments of the present disclosure. The processor 108 comprises a CPU 204 (central processing unit) coupled to support circuits 206 and a memory 208.

The CPU 204 may comprise one or more conventionally available microprocessors. Alternatively, the CPU 204 may include one or more application specific integrated circuits (ASICs). The support circuits 206 are well known circuits used to promote functionality of the CPU 204 and may include, but are not limited to, a cache, power supplies, clock circuits, buses, network cards, input/output (I/O) circuits, and the like.

The memory 208 (e.g., which can be a non-transitory computer readable storage medium) may comprise random access memory, read only memory, removable disk memory, flash memory, and various combinations of these types of memory. The memory 208 is sometimes referred to as main memory and may, in part, be used as cache memory or buffer memory. The memory 208 generally stores the OS 210 (operating system) of the processor 108. The OS 210 may be one of a number of commercially available operating systems such as, but not limited to, SOLARIS from SUN Microsystems, Inc., AIX from IBM Inc., HP-UX from Hewlett Packard Corporation, LINUX from Red Hat Software, Windows 2000 from Microsoft Corporation, and the like.

The memory 208 may store various forms of application software, such as an SVD module 212 (stray voltage detection). Additionally, the memory 208 may store data 214 that is related to the operation of the SVD system 102.

The SVD module 212 processes the electrical signals received from the sensor probe 106 to generate the field strengths at the first, second, and third frequencies. Generally, narrow band filtering is performed at each frequency measured. In some embodiments, the electrical signals from the sensor probe 106 are sampled every 1/960^{th} of a second prior to processing by the SVD module 212. Other sampling rates may alternatively be used, and the electrical signals may additionally be amplified and/or filtered prior to being sampled.

In some embodiments, the received signal may be digitized and the SVD module 212 generates the field strengths at the first, second, and third frequencies by computing a fast Fourier transform (FFT) of the sampled electrical signals to obtain a frequency domain representation of the electric field. The SVD module 212 then computes a magnitude squared of the frequency component at the first frequency, the frequency component at the second frequency, and the frequency component at the third frequency (e.g., the fundamental power line frequency, the second harmonic, and the third harmonic); in one or more alternative embodiments, the SVD module 212 may additionally or alternatively compute strengths of the electric field at one or more other frequencies for use in analyzing stray voltages. In some embodiments, the SVD module 212 may utilize speed and/or location data from the speed/location sensors 110 when computing the electric field strengths, e.g., the speed and/or location data may be utilized to normalize the computed electric field strengths with respect to time and amplitude.

Examples of a technique for computing an electric field strength at 60 Hz, such as that used by the SVD module 212, may be found in commonly assigned U.S. patent 7,248,054, entitled "Apparatus and Method for Detecting an Electric Field", issued July 24, 2007; commonly assigned U.S. patent 7,253,642, entitled "Method for Sensing an Electric Field" and issued August 7, 2007; and commonly assigned U. S. patent application publication number 2009/0195255, entitled "Apparatus and Method for Monitoring and Controlling Detection of Stray Voltage Anomalies" and filed January 21, 2009, the entire contents of each of these applications is incorporated herein by reference. Such a technique may additionally be utilized for computing an electric field strength at other frequencies.

In some other embodiments, a demodulation scheme may be employed to separate the frequencies for determining the field strengths at the fundamental frequency and at least one other frequency.

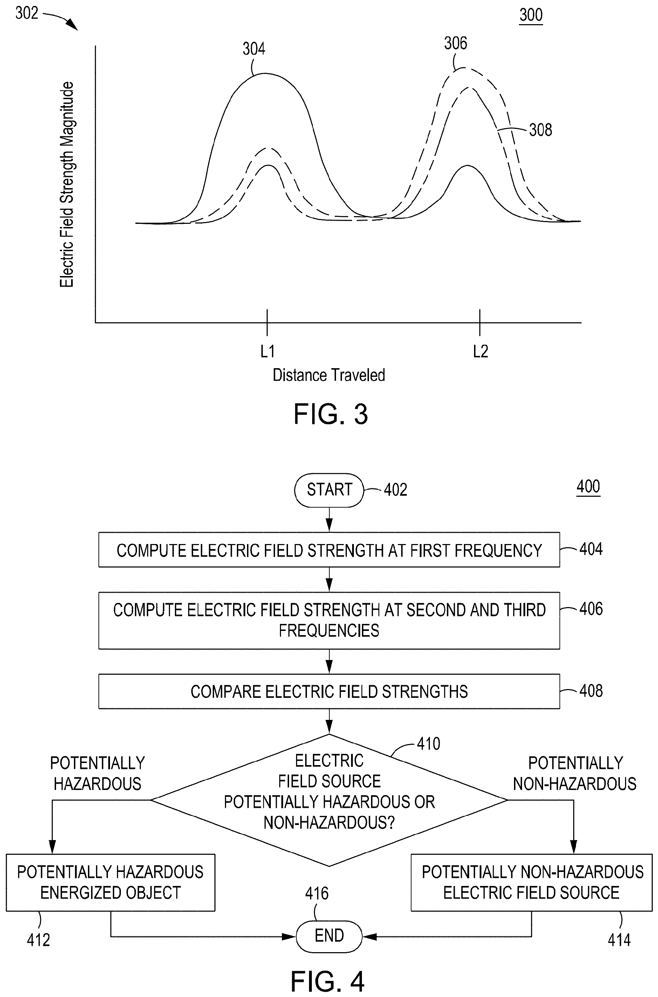

The computed field strengths at the first, second, and third frequencies may be graphically displayed, for example as described below with respect to Figure 3, on the SVD display system 112 for discriminating between potentially hazardous energized objects and potentially non-hazardous electric field sources. The processor 108 may correlate the computed field strengths with location and/or time data from the speed/location sensors 110 for display on the SVD display system 112 and/or for storage in the data 214. In some embodiments, the processor 108 may comprise a transceiver for remotely communicating data.

Figure 3 is a graphical diagram 300 for discriminating between potentially hazardous and non-hazardous electric field sources in accordance with one or more embodiments of the present disclosure. The graphical diagram 300 comprises a graph 302 representing electric field strength magnitude on a Y-axis and distance traveled by the SVD system102 and/or mobile vehicle 104 on an X-axis. The graphical diagram 300 further comprises plot 304, plot 306, and plot 308 of computed field strengths at 60 Hz, 120 Hz, and 180 Hz (i.e., the fundamental frequency of the power line and the first and second harmonics), respectively, along the route traversed by the SVD system102 and/or mobile vehicle 104. Although plots 306 and 308 depict the computed field strengths at harmonics of the power line fundamental frequency, computed field strengths at frequencies not harmonically related may be utilized. In some embodiments, computed field strengths at fewer or more frequencies may be determined and graphically displayed.

At a first location L₁, representative of a location proximate the manhole cover 114, plot 304 (the 60 Hz plot) exhibits a peak magnitude that is much greater than a magnitude of the plot 306 (the 120 Hz plot) and a magnitude of the plot 308 (the 180 Hz plot) at the location L₁, thereby indicating a potentially hazardous charged object proximate the location L₁ (i.e., the manhole cover 114). Additionally or alternatively, other measures may be utilized for determining a potentially hazardous charged object, such as comparing one or more ratios of the computed field strengths to one or more thresholds. At a second location L₂, representative of a location proximate the crossing sign 118, the plot 304 exhibits a much smaller magnitude than a peak magnitude of the plot 306 (120 Hz plot) and the plot 308 (the 180 Hz plot), thereby indicating a potentially non-hazardous source of an electric field proximate the location L₂ (i.e., the crossing sign 118).

In one or more other embodiments, the magnitude of plots 306 and/or 308 need not be greater or less than the magnitude of plot 304 to determine that an electric field source is potentially hazardous or non-hazardous; such a determination may be made based on the existence of the electric field components at 120 Hz and/or 180 Hz and their relative strengths with respect to the electric field strength at 60 Hz. Ratios may be greater than, equal to, or less than 100%.

Figure 4 is a flow diagram of a method 400 for discriminating between potentially hazardous and non-hazardous electric field sources in accordance with one or more embodiments of the present disclosure. In some embodiments, a stray voltage detection (SVD) system, such as the SVD system 102, is utilized to remotely (i.e., in a non-contact fashion) detect objects energized by stray voltages from a power distribution system and to discriminate between potentially hazardous energized objects and potentially non-hazardous sources of electric fields. While traversing a particular route being scanned for stray voltages, the SVD system remotely measures an electric field along the route (i.e., without contact to any objects along the route) and computes strengths of the electric field for identifying and discriminating between potentially hazardous and non-hazardous sources of the electric field.

The method 400 starts at step 402 and proceeds to step 404. At step 404, the electric field at a particular location is remotely measured and a strength of the electric field at the fundamental frequency of the power distribution system ("field strength at a first frequency") is computed, for example, as previously described with respect to Figure 2. In some embodiments, the power distribution system may be a U.S. power distribution system having a fundamental frequency of 60 Hz; alternatively, the power distribution system may have a different fundamental frequency, such as a 50 Hz power distribution system utilized in Europe and parts of Asia.

The method 400 proceeds to step 406, where strengths of the electric field at the second and third harmonics of the fundamental frequency ("field strength at a second frequency" and "field strength at a third frequency", respectively) are computed, for example, also as previously described with respect to Figure 2. In some embodiments, where the power distribution system is a U.S. power distribution system, the second and third harmonics are at 120 Hz and180 Hz, respectively. Generally, narrow band filtering is performed at each frequency measured. In some alternative embodiments, strength of the electric field at one or more other frequencies, not necessarily harmonically related to the fundamental frequency, may additionally or alternatively be determined for analysis of stray voltages. In some other alternative embodiments, the strength of the electric field is only determined at the first and second frequencies for use in the method 400.

The method 400 proceeds to step 408, where the computed field strengths are compared. In some embodiments, the computed field strengths are graphically displayed, such as previously described with respect to Figure 3, for a user to visually distinguish between potentially hazardous and non-hazardous electric field sources based on the relative strengths of the electric field at the first, second, and/or third frequencies. The computed field strengths may be correlated with and displayed with corresponding location and/or time information, such as video imagery and/or time stamp data obtained while measuring the electric field with the SVD system. Additionally or alternatively, the computed field strengths may be analyzed by a processor of the SVD system for determining whether the electric field source is potentially hazardous or non-hazardous; for example, one or more ratios of the computed field strengths may be calculated and compared to one or more thresholds for making such a determination. The SVD system may further generate a visual and/or audible indication to signify whether the electric field source is potentially hazardous or non-hazardous.

In some embodiments, some or all of the data pertaining to the SVD system, such as raw data obtained by the SVD system, data processed by the SVD system, and the like, may be remotely communicated and/or stored for subsequent analysis.

The method 400 proceeds to step 410, where a determination is made whether the comparison of the computed field strengths indicates that the electric field source is potentially hazardous or non-hazardous. In some embodiments, an object may be considered potentially hazardous or non-hazardous based on the relative levels of the computed field strengths, e.g., an object may be considered potentially hazardous if the computed field strength at the fundamental frequency is substantially greater than the computed field strengths at the second and third harmonics at a particular location proximate the object. As previously described, such a determination may be made visually by a user viewing a graphical display of the computed field strengths and/or by a processor of the SVD system analyzing the computed field strengths. Additionally, one or more computed field strengths, either alone or in combination, may exhibit a signature for identifying a specific type of potentially hazardous or non-hazardous object, such as a streetlight, a crossing sign, a manhole cover, or the like. Such a signature may be determined, for example, by comparing a plurality of computed field strengths to one another (e.g., by comparing the field strength at a first frequency to one or more previous computations of field strength at the first frequency taken at the same location), by comparing one or more computed field strengths to one or more signature templates or profiles, by comparing one or more relative values of computed field strengths to one or more thresholds, or by a similar signature identification technique. Such e-field signatures may then be stored for use in identifying potentially hazardous/non-hazardous energized structures.

For objects that may be characterized by such a signature and determined to be typically non-hazardous objects, the SVD system may provide a specific indication that the object is typically non-hazardous and requires no further investigation. Alternatively, the SVD system may suppress an indication (e.g., a visual alarm, an audible alarm, or the like) of a detected electric field radiated from the object. Such characterization of typically non-hazardous objects may thereby improve the speed and efficiency of identifying potentially hazardous objects by allowing the user to bypass typically non-hazardous objects that are radiating an electric field.

If, at step 410, it is determined that the comparison of the computed field strengths indicates that that the object is potentially hazardous, the method 400 proceeds to step 412 and concludes that the object is a potentially hazardous energized object. In some embodiments, the SVD system may provide a visual and/or audible indication of such a conclusion. The method 400 then proceeds to step 416 where it ends.

If, at step 410, it is determined that the comparison of the computed field strengths indicates that the electric field source is potentially non-hazardous, the method 400 proceeds to step 414 and concludes that the object is a potentially non-hazardous electric field source. In some embodiments, the SVD system may provide a visual and/or audible indication of such a conclusion. The method 400 then proceeds to step 416 where it ends.

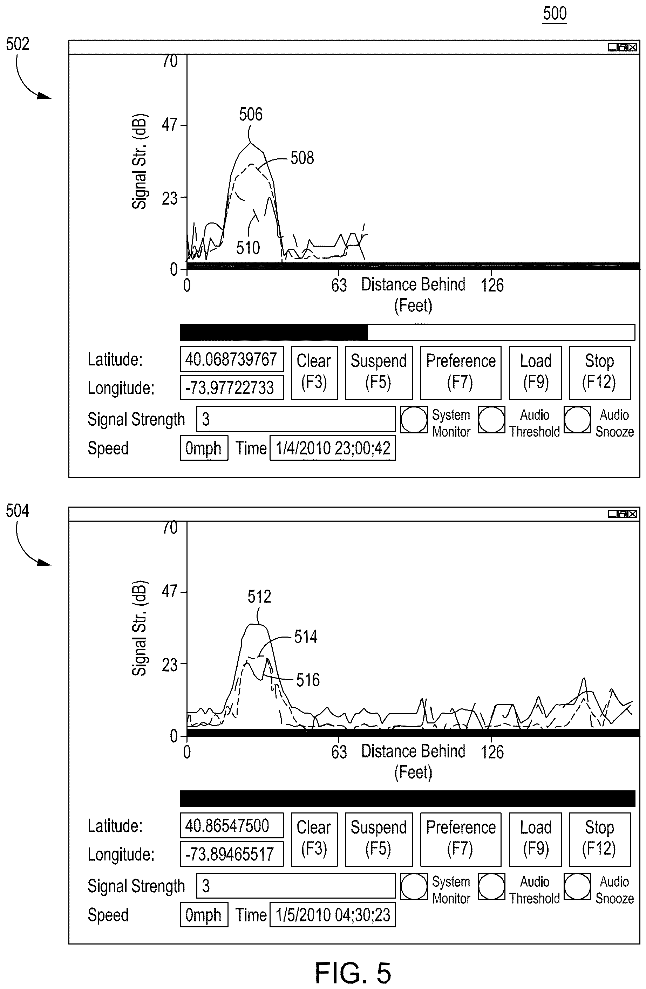

Figure 5 is a pair of graphical diagrams 500 depicting exemplary data for discriminating between potentially hazardous and non-hazardous electric field sources in accordance with one or more embodiments of the present disclosure. The graphical diagrams 500 comprise graphs 502 and 504 representing electric field strength magnitude on a Y-axis and distance traveled by the SVD system102 and/or mobile vehicle 104 on an X-axis. In some embodiments, such as the embodiment depicted in Figure 5, the power distribution system operates at a fundamental frequency of 60 Hz; alternatively, the power distribution system may operate at a different fundamental frequency, such as 50 Hz.

Graph 502 comprises plots 506, 508, and 510 of computed field strengths at 60 Hz, 120 Hz, and 180 Hz (i.e., the fundamental frequency of the power line and the first and second harmonics), respectively, along a first route traversed by the SVD system102 and/or mobile vehicle 104. Plots 506, 508, and 510 are overlaid on correlated visual imagery additionally obtained along the first route by the SVD system 102. Although plots 508 and 510 depict computed field strengths at harmonics of the power line fundamental frequency, computed field strengths at frequencies not harmonically related may be utilized. At location L₁, the relative strengths of the plots 506, 508, and 510 indicate a potentially non-hazardous source of an electric field proximate the location L₁. In some embodiments, the plots 506, 508, and/or 510, or a combination thereof, may exhibit a signature identifying a specific type of potentially non-hazardous electric field source, such as a pedestrian crossing sign that emits an electric field pattern similar to that of a potentially hazardous energized object but does not exhibit a voltage at its surface. Such a signature may be determined, for example, by a relative comparison of the plots 506, 508, and/or 510, by comparing one or more of the plots 506, 508, and 510 to one or more signature templates or profiles, or by a similar signature identification technique.

Graph 504 comprises plots 512, 514, and 516 of computed field strengths at 60 Hz, 120 Hz, and 180 Hz, respectively, along a second route traversed by the SVD system102 and/or mobile vehicle 104. Plots 512, 514, and 516 are overlaid on correlated visual imagery additionally obtained along the second route by the SVD system 102. Although plots 514 and 516 depict computed field strengths at harmonics of the power line fundamental frequency, computed field strengths at frequencies not harmonically related may be utilized. At location L₂, the relative strengths of the plots 512, 514, and 516 indicate a potentially hazardous charged object proximate the location L₂. In some embodiments, the plots 512, 514, and/or 516, or a combination thereof, may exhibit a signature identifying a specific type of potentially hazardous electric field source, such as a streetlight, a manhole cover, or the like, having a potentially hazardous energized surface. Such a signature may be determined, for example, by a relative comparison of the plots 512, 514, and/or 516; by comparing one or more of the plots 512, 514, and 516 to one or more signature templates or profiles; or by a similar signature identification technique.

As noted above, provided herein are improved artificial intelligence-based stray voltage detection systems configured to determine potentially hazardous energized objects. In at least some embodiments, the methods and apparatus described herein can be configured to determine potentially hazardous energized objects using one or more advanced object recognition algorithms and some or all of the information obtained from the system 100, as described in greater detail below. The inventors have found that by leveraging one or more advanced object recognition algorithms, such as the you only look once (YOLO) object detection system, the methods and apparatus described herein can detect subtle visual cues and anomalies that may indicate the presence of stray voltage.

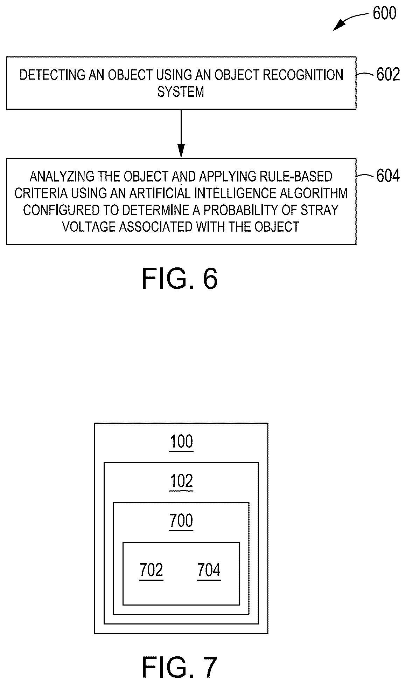

For example. Figure 6 is a flowchart of a method 600 for determining a stray voltage source, and Figure 7 is a block diagram of the system 100 comprising an apparatus 700 for determining a stray voltage source in accordance with one or more embodiments of the present disclosure.

For example, at 602, the method 600 can comprise detecting an object using an object recognition system. For example, in at least some embodiments, the apparatus 700 can comprise an object recognition system 702 that is configured to detect an object (e.g., a real-time object recognition system), such as the YOLO system.

Next, at 604, the method 600 can comprise analyzing the object and applying rule-based criteria using an artificial intelligence algorithm configured to determine a probability of stray voltage associated with the object. For example, in at least some embodiments, the apparatus 700 can comprise an artificial intelligence algorithm 704 configured to analyze the object and apply rule-based criteria to determine a probability of stray voltage associated with the object. The rule-based criteria is a comprehensive rule base that in conjunction with the object recognition system 702 allows the artificial intelligence algorithm 704 to analyze and interpret environmental images and/or data to identify potential sources of stray voltage.

The object recognition system 702 and the artificial intelligence algorithm 704 can be components of the system 100 and in operable communication with one or more other components of the system 100. Alternatively, the object recognition system 702 and the artificial intelligence algorithm 704 can be components separate from the system 100 and in operative communication therewith and the components of the system 100. In at least some embodiments, the object recognition system 702 and the artificial intelligence algorithm 704 can be a component of the SVD system 102, mounted on the mobile vehicle 104 (e.g., similarly to the sensor probe 106), and in operative communication with the processor 108 (and the memory 208).

In at least some embodiments, the artificial intelligence algorithm 704 is configured to automate one or more tasks/operations of the SVD system 102 to ensure the availability of higher quality actionable information through a generative-artificial intelligence (Gen-AI) large language models (LLM), which can be trained on data and documents. That is, the LLM are neural networks, which are machine learning models that take an input and perform mathematical calculations to produce an output. For example, in at least some embodiments, the artificial intelligence algorithm 704 can be trained on a dataset of environmental images annotated with information relating to at least one of stray voltage occurrences, false positives, or common sources of stray voltage. For example, the dataset of environmental images (e.g., graphs 502 and 504 of Figure 5) can be obtained via the method 400. Training the artificial intelligence algorithm 704 allows the artificial intelligence algorithm 704 to distinguish between genuine stray voltage sources and common benign elements, which may otherwise trigger a false positive. Once a potential genuine stray voltage source is detected, the artificial intelligence algorithm 704 is configured to apply the rule base, which can be developed from historical data and expert input, that includes decision-making criteria to determine the likelihood of actual stray voltage presence. The rule base enables the artificial intelligence algorithm 704 to decide autonomously whether additional testing or interventions are necessary, thereby reducing human error and increasing the efficiency of operational procedures. Accordingly, in at least some embodiments, the artificial intelligence algorithm 704 can be configured to determine between a stray voltage and a false stray voltage based on the dataset of environmental images.

In at least some embodiments, the artificial intelligence algorithm 704 can be configured to autonomously output (e.g., via the SVD display system 112) for further testing to a user (e.g., operator/technician) based on the dataset of environmental images. That is, the SVD display system 112 can alert the operator/technician (or response team(s)) with details about detected stray voltage sources and the artificial intelligence algorithm 704 evaluation outcome, thus providing options for immediate intervention if necessary.

In at least some embodiments, the rule-based criteria and the dataset of environmental images are periodically updated, and the artificial intelligence algorithm 704 can be configured to apply an updated rule-based criteria to determine a probability of stray voltage associated with the object and is further trained on an updated dataset of environmental images. In doing so, the rule-based criteria and training dataset can be updated in response to newly identified stray voltage incidents to continuously improve the accuracy and response capability of the apparatus 700.

The apparatus 700 provides significant advancements in safety and operational efficiency for industries where stray voltage detection is critical, such as utilities, construction, and transportation sectors. By automating the detection and preliminary evaluation process, the apparatus 700 can speed up response times and also enhance the accuracy and reliability of stray voltage assessments. Additionally, the apparatus 700 can reduce the reliance on operator/technician situational awareness and experience by using machine learning models trained on a comprehensive database of annotated images depicting both genuine and false stray voltage scenarios.

While the foregoing is directed to embodiments of the present disclosure, other and further embodiments of the disclosure may be devised without departing from the basic scope thereof, and the scope thereof is determined by the claims that follow.

## Claims

1. An apparatus for determining a stray voltage source, comprising:
an object recognition system configured to detect an object; and
an artificial intelligence algorithm configured to analyze the object and apply rule-based criteria to determine a probability of stray voltage associated with the object.

2. The apparatus of claim 1, wherein the object recognition system can be a you only look once system.

3. The apparatus of claim 1, wherein the artificial intelligence algorithm is trained on a dataset of environmental images annotated with information relating to at least one of stray voltage occurrences, false positives, or common sources of stray voltage.

4. The apparatus as in any of claims 1 to 3, wherein the artificial intelligence algorithm is further configured to determine between a stray voltage and a false stray voltage based on the dataset of environmental images.

5. The apparatus as in any of claims 1 to 3, wherein the artificial intelligence algorithm is further configured to autonomously output for further testing to a user based on the dataset of environmental images.

6. The apparatus as in any of claims 1 to 3, wherein the rule-based criteria and the dataset of environmental images are periodically updated, and wherein the artificial intelligence algorithm is further configured to apply an updated rule-based criteria to determine the probability of stray voltage associated with the object and is further trained on an updated dataset of environmental images.

7. A method for determining a stray voltage source, comprising:
detecting an object using an object recognition system; and
analyzing the object and applying rule-based criteria using an artificial intelligence algorithm configured to determine a probability of stray voltage associated with the object.

8. The method of claim 7, wherein the object recognition system can be a you only look once system.

9. The method of claim 7, further comprising training the artificial intelligence algorithm on a dataset of environmental images annotated with information relating to at least one of stray voltage occurrences, false positives, or common sources of stray voltage.

10. The method as in any of claims 7 to 9, further comprising determining between a stray voltage and a false stray voltage based on the dataset of environmental images.

11. The method as in any of claims 7 to 9, further comprising autonomously outputting for further testing to a user based on the dataset of environmental images.

12. The method as in any of claims 7 to 9, further comprising periodically updating the rule-based criteria and the dataset of environmental images, and further comprising applying an updated rule-based criteria to determine the probability of stray voltage associated with the object and training the artificial intelligence algorithm on an updated dataset of environmental images.

13. A non-transitory computer readable storage medium having instructions stored thereon that when executed by a processor perform a method for determining a stray voltage source, comprising:
detecting an object using an object recognition system; and
analyzing the object and applying rule-based criteria using an artificial intelligence algorithm configured to determine a probability of stray voltage associated with the object.

14. The non-transitory computer readable storage medium of claim 13, wherein the object recognition system can be a you only look once system.

15. The non-transitory computer readable storage medium of claim 13, wherein the method further comprises training the artificial intelligence algorithm on a dataset of environmental images annotated with information relating to at least one of stray voltage occurrences, false positives, or common sources of stray voltage; and/or
wherein the method further comprises determining between a stray voltage and a false stray voltage based on the dataset of environmental images; and/or
wherein the method further comprises autonomously outputting for further testing to a user based on the dataset of environmental images; and/or
wherein the method further comprises periodically updating the rule-based criteria and the dataset of environmental images, and further comprising applying an updated rule-based criteria to determine the probability of stray voltage associated with the object and training the artificial intelligence algorithm on an updated dataset of environmental images.
